# EUROPÄISCHE PATENTANMELDUNG

(11) **EP 2 385 388 A1**
(43) Veröffentlichungstag der Anmeldung: **09.11.2011**
(21) Anmeldenummer: 11164699.8
(22) Anmeldetag: 04.05.2011
(51) Int. Cl.: G01R 33/563

(54) **Vorrichtung und Verfahren zur Kontrastmittelmessung**

(30) Priorität: 07.05.2010 DE 102010028749
(71) Anmelder: Universitätsklinikum Freiburg, 79106 Freiburg (DE)
(72) Erfinder: Kiselev, Valerij Dr., 79102 Freiburg (DE); Gall, Peter Dr., 79114 Freiburg (DE); Kellner, Elias, 74193 Schwaigern (DE)
(74) Vertreter: Kohler Schmid Möbus

(57) **Zusammenfassung**

Die Erfindung betrifft eine Tomographieeinrichtung (3) zur Erzeugung von Magnetresonanz-(MR-) Bildern eines in einem Messvolumen der Tomographieeinrichtung (3) angeordneten Körperteils eines Lebewesens (1), mit einer ersten Messeinheit (4a) zur Aufnahme einer ortsaufgelösten zeitlichen Reihe von MR-Bildern des zu untersuchenden Körperteils, wobei die Zeitreihe von MR-Bildern den Durchgang eines in die Blutbahn des Lebewesens injizierten Kontrastmittels durch ein im zu untersuchenden Körperteil befindliches Organ darstellt, welche dadurch gekennzeichnet ist, dass mindestens eine weitere Messeinheit (4b) vorgesehen ist, die eine lokale Aufnahmespule umfasst, welche in der Nähe mindestens einer Arterie, die den in der Tomographieeinrichtung angeordneten Körperteil (2) des Lebewesens versorgt, die Konzentration des Kontrastmittels zeitaufgelöst und zeitgleich mit der Messung der durch die erste Messeinheit bestimmten zeitlichen Reihe von MR-Bildern misst. Durch diese Erfindung werden ein System und ein dazugehöriges Verfahren bereitgestellt, welche eine gleichzeitige Messung von großen Gefäßen und Gewebe mit ein und derselben Sequenz bei angepasstem dynamischem Bereich ermöglichen.

## Beschreibung

Die Erfindung betrifft eine Tomographieeinrichtung zur Erzeugung von Magnetresonanz-(MR-) Bildern eines in einem Messvolumen der Tomographieeinrichtung angeordneten Körperteils eines Lebewesens, mit einer ersten Messeinheit zur Aufnahme einer ortsaufgelösten zeitlichen Reihe von MR-Bildern des zu untersuchenden Körperteils, wobei die Zeitreihe von MR-Bildern den Durchgang eines in die Blutbahn des Lebewesens injizierten Kontrastmittels durch ein im zu untersuchenden Körperteil befindliches Organ darstellt.

Eine derartige Vorrichtung ist aus EP 0 958 503 B1 bekannt.

Ziel einer dynamischen suszeptibilitätsgewichteten (DSC) Messung ist es Perfusionsparameter wie cerebrales Blutvolumen (CBV), cerebraler Blutfluss (CBF) und mittlere Transitzeit (MTT) lokal aufgelöst zu bestimmen. Injiziert man einen Kontrastmittelbolus in die Armvene so erzeugt die Passage dieses Bolus durch das Gehirn einen zeitlich veränderlichen Kontrast im Magnet-Resonanz-(MR) Bild. Schnelle MR-Sequenzen (z.B. echo planar imaging (EPI)) ermöglichen es die Passage dieses Kontrastmittelbolus zeitlich und örtlich aufgelöst zu messen. Aus so gemessenen Zeitreihen lässt sich die Änderung der Relaxationsrate für jedes Voxel bestimmen. Aus der Änderung der Relaxationsrate kann man die Kontrastmittelkonzentration näherungsweise bestimmen.

Die Bestimmung der oben genannten Parameter erfolgt durch Zuhilfenahme des tracer kinetic model [1, 2, 3]. Dieses Model stellt einen kausalen Zusammenhang zwischen dem Verlauf der Kontrastmittelkonzentration in der arteriellen Zufuhr (Cᵢₙ (t)) und dem Verlauf der Kontrastmittelkonzentration im betrachteten Voxel (Cₜ (t)). Aus dem Vergleich der beiden Verläufe können die oben genannten Parameter bestimmt werden.

Der dynamische Bereich der Messung ist beschränkt durch die Konzentration des Kontrastmittels im Vergleich zur Echozeit (TE) der verwendeten MR-Sequenz. Bei kurzem TE ist es möglich die Änderung der Relaxationsrate in großen Gefäßen zu messen, wohingegen in Gewebe, wo CBV sehr klein ist, der Effekt des Kontrastmittels nicht mehr sichtbar ist. Bei langem TE ist der Effekt im Gewebe zwar gut sichtbar, die Magnetisierung in großen Gefäßen ist dann jedoch nahezu vollständig relaxiert und gibt dadurch kein Signal. Eine sehr kurze Echozeit würde zwar eine Messung der arteriellen Blutes ermöglichen, jedoch ist sie durch die Anforderungen der Bildgebung nach unten so beschränkt, dass in Arterien die Magnetisierung stark relaxiert ist. In einem Standardprotokoll wird TE Gewebe optimiert gewählt. Es gibt Ansätze bei denen mehrere Echos von derselben Anregung aufgenommen werden [4], jedoch zeigt sich, dass die kürzeste Echozeit immer noch zu lang für die Messung des arteriellen Signals ist.

Darüber hinaus führt die Präsenz von Kontrastmittel zu einer beachtlichen Verschiebung der Larmorfrequenz. Dadurch wird die Ortskodierung bei schnellen MR-Sequenzen wie der EPI-Sequenz gestört. Dies äußert sich durch eine scheinbare Bewegung eines großen Gefäßes durch das Bild. Die Richtung der Bewegung hängt dabei von dem verwendetet Kodierungsschema ab.

Das tracer kinetic Modell verlangt, dass Cin der direkte Input des betrachteten Voxels ist. Wie oben dargelegt, wird ersatzweise die AIF weiter entfernt im Gefäßbaum bestimmt. Auf diesem zusätzlichen Weg werden aufgrund der Blutflussverhältnisse die Form und die Ankunftszeit des Bolus verändert. Um diese Effekte zu minimieren wurde vorgeschlagen für ein gegebenes Gehirnareal eine individuelle AIF zu bestimmen anstatt einer globalen AIF [5]. Damit einhergehend ist jedoch angesichts der verhältnismäßig niedrigen räumlichen Auflösung, dass solche lokale AlFs in Arterien die sehr kleinen im Vergleich zur Voxelgröße sind bestimmt werden. Dieser so genannte Partialvolumeneffekt führt zu einem gravierenden Verlust des arteriellen Beitrags im gemessenen Signal.

Um Partialvolumeneffekte zu minimieren haben van Osch et al. in [6] vorgeschlagen das komplexe Signal während der DSC Messung aufzuzeichnen. Wählt man ein Gefäß aus, das parallel zum Magnetfeld ist, so kann man den Beitrag des großen Gefäßes von dem des umgebenden Gewebes trennen. Ein solches Gefäß ist jedoch nur schwer auffindbar. Gerade Blutgefäße, die als lokale AIF benutzt werden können, liegen im Allgemeinen nicht parallel zum Magnetfeld und entziehen sich damit der Korrektur. Große Gefäße wie die Carotis Interna liegen zwar nahezu parallel zum Magnetfeld, die hohe Kontrastmittelkonzentration pro Voxel übersteigt jedoch den dynamischen Bereich einer typischen Messung.

Die momentan am häufigsten verwendete Methode der DSC-Auswertung beruht auf der Selektion einer globalen AIF. Die Selektion kann manuell erfolgen, indem der Benutzer ein Voxel auswählt, dessen Signal er für eine geeignete AIF hält.

Es hat sich gezeigt, dass die resultierenden Perfusionsparameter stark vom Benutzer abhängen. Um vergleichbarere und reproduzierbare Ergebnisse zu erhalten wurden deswegen Ansätze zur automatischen AIF-Selektion vorgeschlagen [7, 8, 9]. Ebenso wie bei die manuelle Selektion erhält man eine durch Partialvolumeneffekte und scheinbare Bewegung verzerrte AIF.

In dem Patent EP 0 958 503 B1 wird vorgeschlagen AIF im Hals des Patienten zu messen. Da die Aufnahme des Signals nicht anhand einer separaten Spule erfolgt bleibt das Problem des beschränkten dynamischen Bereiches weiterhin bestehen.

Ein weiteres Problem bei der Bestimmung der Perfusionsparameter ist die zeitliche Auflösung der Boluspassage. Diese ist gerade für Arterien wo der Blutfluss hoch ist unzureichend.

Die oben genannten Probleme des Standes der Technik lassen sich wie folgt zusammenfassen:
● Stark unterschiedliche Konzentration des Kontrastmittels in großen Gefäßen und Gewebe machen die genaue, gleichzeitige Messung von großen Gefäßen und Gewebe mit ein und derselben Sequenz unmöglich.
●Das führt zu einem Abfall des arteriellen Signals unterhalb des Rauschniveaus sowie zu einer Verschiebung der Phase des Signals.
● Die zeitliche Auflösung der DSC Messung ist gerade für die AIF sehr niedrig.
● Arterielle Inputfunktionen die mit Mitteln des Standes der Technik bestimmt werden können sind von Partialvolumeneffekten verzerrt.

### Aufgabe der Erfindung

Der vorliegenden Erfindung liegt demgegenüber die Aufgabe zugrunde, ein System und ein dazugehöriges Verfahren bereitzustellen, das eine gleichzeitige Messung von großen Gefäßen und Gewebe mit ein und derselben Sequenz bei angepasstem dynamischem Bereich ermöglicht.

### Kurze Beschreibung der Erfindung

Diese Aufgabe wird erfindungsgemäß auf ebenso überraschend einfache wie wirkungsvolle Weise dadurch gelöst, dass mindestens eine weitere Messeinheit vorgesehen ist, die eine lokale Aufnahmespule umfasst, welche in der Nähe mindestens einer Arterie, die den in der Tomographieeinrichtung angeordneten Körperteil des Lebewesens versorgt, die Konzentration des Kontrastmittels zeitaufgelöst und zeitgleich mit der Messung der durch die erste Messeinheit bestimmten zeitlichen Reihe von MR-Bildern misst.

Nach dem Stand der Technik gibt es nur eine Hauptmesseinheit, mit der versucht wird, Gefäße und Gewebe zu messen. Die Erfindung besteht nun darin, dass mindestens eine weitere Messeinheit zur benachbarten Anordnung an mindestens eine Arterie vorgesehen ist. Diese zusätzliche Messeinheit misst im Wesentlichen zeitgleich mit der durch die Tomographieeinrichtung bestimmten Zeitreihe die Kontrastmittelkonzentration an der mindestens einen Arterie.

Eine typische, aber nicht ausschließliche Anwendung der Erfindung ist die Untersuchung des Gehirns eines zu untersuchenden menschlichen Patienten. In diesem Fall würden unter der mindestens einen Arterie die Karotiden im Hals verstanden, die das Gehirn mit Blut versorgen.

Unter benachbarter Anordnung ist dabei zu verstehen, dass die Arterie im Sensitivitätsbereich der weiteren, zusätzlichen Messeinheit liegt.

Im Wesentlichen zeitgleich bedeutet, dass der zeitliche Versatz der Messung mit der weiteren Messeinheit kleiner als die Zeitauflösung der durch die Tomographieeinrichtung gemessenen Zeitreihe ist. Diese Messung kann also zeitgleich oder geringfügig zeitlich versetzt erfolgen.

Die mindestens eine weitere Messeinheit kann an eine oder mehrere Arterien benachbart angeordnet werden. Die weiteren Messeinheiten können aber auch an einer Arterie an verschiedenen Orten angeordnet werden.

### Bevorzugte Ausführungsformen der Erfindung

Eine besonders vorteilhafte Ausführungsform der Erfindung ist dadurch gekennzeichnet, dass die weitere Messeinheit als Oberflächenspule ausgebildet ist. Die als Oberflächenspule ausgestaltete Messeinheit kann an der Körperoberfläche des Säugers nahe liegenden Arterien besonders einfach angebracht werden.

Bei einer weiteren Ausführungsform ist die weitere Messeinheit an einem eigenen Datenaufnahmekanal der Tomographieeinrichtung angeschlossen. Durch die Verwendung eines eigenen Datenaufnahmekanals wird erreicht, dass die Messung mit der Bestimmungseinrichtung durch die mindestens eine weitere Messeinheit nicht beeinträchtigt wird. Dadurch ist die im Wesentlichen zeitgleiche Messung möglich.

Vorteilhaft ist eine Ausführungsform der Erfindung, bei der die weitere Messeinheit ein kleineres Messvolumen als die erste Messeinheit umschließt. Die weitere Messeinheit ist dadurch handlicher und kann flexibel auch an schwer erreichbaren Stellen eines Körpers angebracht werden.

Eine besonders bevorzugte Ausführungsform der Erfindung weist mindestens zwei weitere Messeinheiten auf. Durch die Verwendung mindestens zweier Messeinheiten, wodurch eine räumliche Differenzierung von Signalquellen in dem zu untersuchenden Lebewesen möglich ist, wird erreicht, dass die AIF für jede Arterie separat bestimmt werden kann. Darüber hinaus kann die beobachtete Arterie vom umgebenden Gewebe differenziert betrachtet werden.

Zu der Erfindung gehört auch ein Verfahren zum Betrieb einer erfindungsgemäßen Tomographieeinrichtung, welches dadurch gekennzeichnet ist, dass eine Anregung der Magnetisierung des innerhalb der mindestens einen Arterie geführten Blutes und/oder Kontrastmittels des zu untersuchenden Lebewesens zeitlich vor und/oder nach dem Bildgebungsteil der Messsequenz der ersten Messeinheit erfolgt. Durch die Anregung der Magnetisierung zur Messung der Kontrastmittelkonzentration zu einem Zeitpunkt bei dem die Tomographieeinrichtung keine Bildgebung durchführt, wird erreicht, dass die Messung mit der Tomographieeinrichtung nicht gestört wird. Die für die Messung mit der mindestens einen weiteren Messeinheit benötigte Anregung der Magnetisierung erfolgt also zu einem Zeitpunkt, bei dem die von der Tomographieeinrichtung verwendeten Sequenz radiofrequenzpulsfreie und gradientenfreie Zeitfenster zur Verfügung stehen.

Eine weitere Variante des Verfahrens ist dadurch gekennzeichnet, dass ein Auslesevorgang der weiteren Messeinheit zeitlich vor und/oder nach dem Bildgebungsteil der Messsequenz der ersten Messeinheit erfolgt.

Als besonders vorteilhaft muss eine Variante der erfindungsgemäßen Verfahrens gesehen werden, bei der die Anregung der Magnetisierung des innerhalb der Arterie geführten Blutes und/oder Kontrastmittels des zu untersuchenden Lebewesens vor und/oder nach dem Bildgebungsteil der Messsequenz der ersten Messeinheit erfolgt, wobei der Auslesevorgang der weiteren Messeinheit während und/oder nach dem Bildgebungsteil der Messsequenz der ersten Messeinheit erfolgt. Dadurch wird erreicht, dass für die Messung durch die mindestens eine Messeinheit besonders viel Zeit zur Verfügung steht. Außerdem kann die Messung durch die mindestens eine Messeinheit nach einer erneuten Anregung der Magnetisierung nach dem Bildgebungsteil der Messsequenz der Bestimmungseinrichtung wiederholt werden.

Eine weitere vorteilhafte Variante des erfindungsgemäßen Verfahrens ist dadurch gekennzeichnet, dass die Anregungsschicht so dick gewählt ist, dass die durch den zeitlich veränderlichen Blutfluss in der mindestens einen Arterie verursachte Änderung des von weiteren Messeinheit aufgenommenen Signals vernachlässigbar klein ist. Dadurch wird erreicht, dass der zeitlich veränderliche Blutfluss in der mindestens einen Arterie nicht ermittelt werden muss. Dies ermöglicht eine besonders einfache Auswertung des Signals von der mindestens einen Messeinheit.

Zu bevorzugen ist eine Variante des erfindungsgemäßen Verfahrens bei dem mindestens zwei Anregungsschichten verwendet werden. Durch die Anregung mehrerer Schichten wird erreicht, dass der Blutfluss in der mindestens einen Arterie ermittelt werden kann. Der ermittelte Blutfluss kann zur Korrektur der durch den Blutfluss modulierten Signale von der mindestens einen weiteren Messeinheit verwendet werden. Diese Ausgestaltung ist besonders dann von Vorteil, wenn das zu untersuchende Lebewesen keine ausreichend dicke Anregungsschicht aufgrund seiner Anatomie zulässt.

Bei einer weiteren Variante des erfindungsgemäßen Verfahrens ist der Kontrast zwischen der Arterie und dem die Arterie umgebenden Gewebe über die jeweiligen Flipwinkel der Anregungen der Magnetisierung einstellbar. Durch die angepasste Wahl der Flipwinkel der Anregung der Magnetisierung wird auf vorteilhafte Weise erreicht, dass der Kontrast zwischen der beobachteten Arterie und des umgebenden Gewebes größtmöglich eingestellt werden kann, so dass eine einfache Bestimmung durch die mindestens eine Messeinheit der arteriellen Kontrastmittelkonzentration möglich ist.

Eine andere Variante des erfindungsgemäßen Verfahrens sieht vor, dass nach der Anregung und dem Auslesevorgang vor dem Bildgebungsteil der Messsequenz zusätzlich eine oder mehrere Anregungen mit Auslesevorgang nach dem Bildgebungsteil der Messsequenz mit variablen Anfangszeiten angeschlossen werden. Dadurch wird erreicht, dass die transversale, die Arterie umgebende Gewebemagnetisierung zusätzlich unterdrückt wird. Darüberhinaus kann die zeitliche Abtastrate entsprechend der Anzahl der Auslesevorgänge erhört werden.

Vorteilhaft ist eine Variante des erfindungsgemäßen Verfahrens, bei dem die Bestimmung der Kontrastmittelkonzentration durch Isolation des durch das Kontrastmittel verursachten Spektrumanteils aus dem gemessenen Signal erfolgt. Durch die Bestimmung der Kontrastmittelkonzentration anhand des von der mindestens einen weiteren Messeinheit gemessenen komplexen Spektrums wird erreicht, dass die Konzentration besonders stabil und genau durch Isolierung der entsprechenden Resonanzfunktion erfolgen kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematische Darstellung eines erfindungsgemäßen Tomographen mit einer weiteren Messeinheit; und
- Fig. 2: ein Sequenzdiagramm für einen erfindungsgemäßen Tomographen; obere Zeile: alle Anregungspulse und Auslesung der ersten Messeinheit; mittlere Zeile: Reaktion der angeregten Schicht auf die Anregung; untere Zeile: Auslesesequenz der weiteren Messeinheit; linke Hälfte: erste angeregte Schicht; rechte Hälfte: zweite angeregte Schicht.

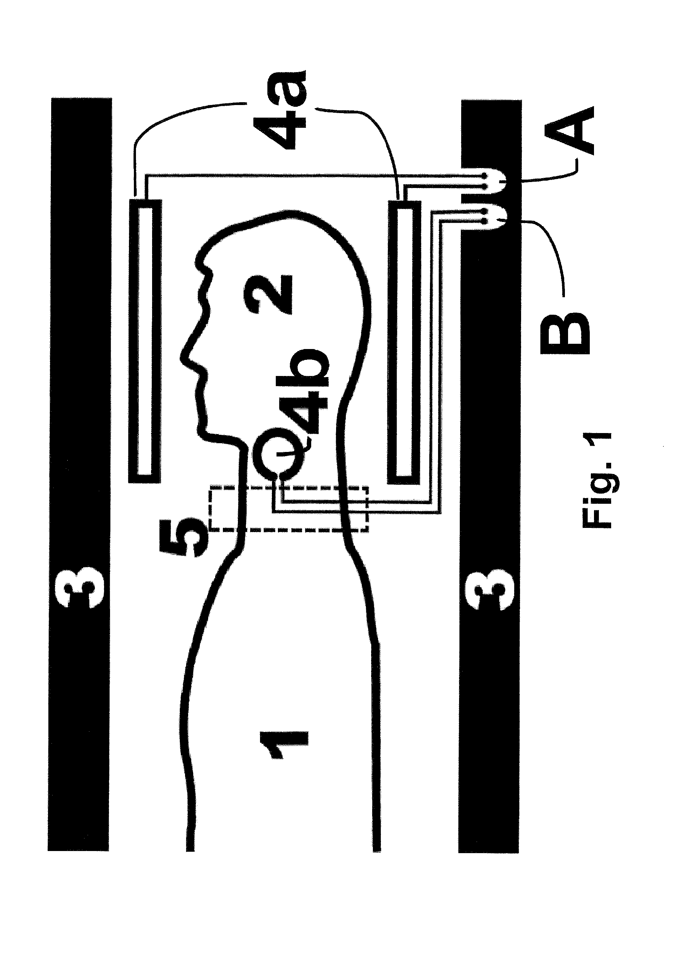

In der schematischen Darstellung **Fig. 1** ist ein **Körperteil 2** (in diesem Fall der Kopf) des zu untersuchenden **Lebewesens 1** (in diesem Fall ein Mensch) in dem durch die **erste Messeinheit 4a** definierten Messvolumen des **Tomographen 3** positioniert. Die als Oberflächenspule ausgebildete **weitere Messeinheit 4b** wird am Hals des Patienten angebracht. Die Magnetisierung aus der **Anregungsschicht 5** dient als Signalquelle für die weitere Messeinheit 4b.

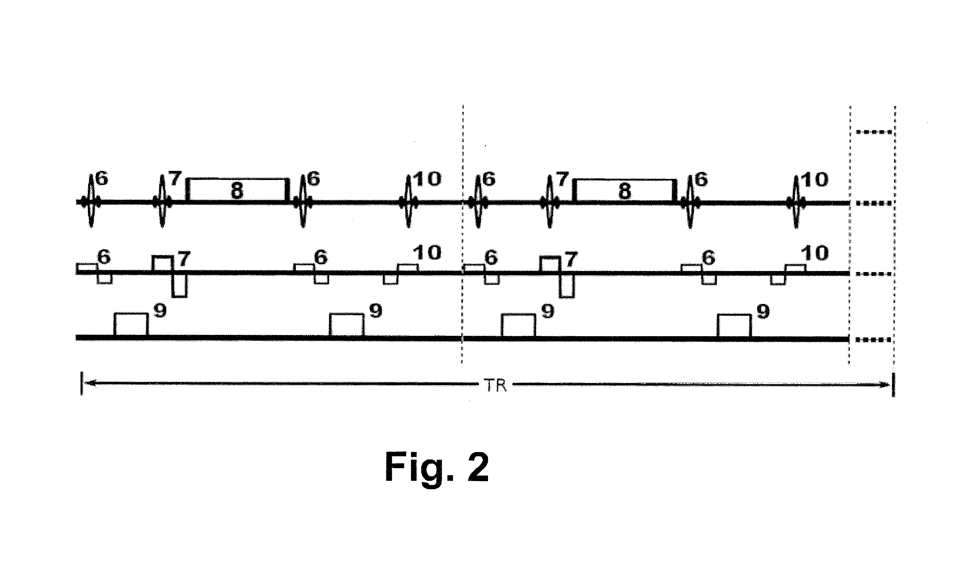

In **Fig. 2** ist nun die Messsequenz für den Betrieb eines erfindungsgemäßen Tomographen dargestellt. Bei der Sequenz wird nach der **Anregung** der **Gewebe-Magnetisierung 7** in jeder Schicht ein **Bildgebungsblock 8** eingefügt um die in-Schicht Kodierung durchzuführen. Die Anregung der **Kontrastmittel-Magnetisierung 6** in der Schicht die zum **Signal 9** in der weiteren Messeinheit 4b führt kann vor und/oder nach dem Bildgebungsblock 8 und der Anregung 7 erfolgen. Im Falle der Anregung vor dem Bildgebungsblock 8 muss der Einfluss der Bildgebungsgradienten während des Bildgebungsblockes 8 bei der Interpretation des Signals von der weiteren Messeinheit 4b berücksichtigt werden.

Das Signal der weiteren Messeinheit 4b wird mit dem Ende des Anregungspulses 6 mit Hilfe mindestens eines eigenen **Datenaufnahmekanals** B aufgezeichnet. Dieses Signal ist um die Anzahl der Schichten zeitlich besser abgetastet als die Zeitreihe die für jedes Voxel gemessen wird.

Der hohe und pulsatile Fluss, in der Systole etwa 1mls, in der Diastole etwa 0.2 m/s, führt zu einem örtlichen Versatz, sowie zu einer Verschmierung der für die weitere Messeinheit 4b benötigten **angeregten Schicht 5**. Wenn der örtliche Versatz in der Größenordnung der Dicke der angeregten Schicht 5 ist, wird das von der weiteren Messeinheit 4b gemessene Signal signifikant vom Fluss moduliert werden. Diese Modulation muss unterdrückt oder bestimmt werden, um die Konzentration des Kontrastmittels zu bestimmen.

Eine Unterdrückung gelingt, wenn die angeregte Schicht 5 so dick gewählt wird, wie die Messgegebenheiten es zulassen. Eine typische geeignete Schichtdicke ist etwa 10 cm. Bei einer Flussgeschwindigkeit von 1 m/s beträgt der örtliche Versatz der schnellsten Schichtfront bei 5 cm innerhalb der Zeitdauer des Bildgebungsblockes von 50 ms. Da die Durchmischung von angeregter Magnetisierung mit nicht angeregter Magnetisierung am Rand der Schicht 5 erfolgt, kann durch die Wahl einer dicken Schicht dieser Effekt minimiert werden.

Die Parameter der Modulation können bestimmt werden, indem mehrere dünne Schichten in variablen Abständen von dem Ort der weiteren Messeinheit 4b angeregt werden. Die durch den Blutfluss verursachte Modulation wird dadurch kodiert. Das Kodierungsschema wird dann genutzt um die Flussmodulation aus den mit den weiteren Messeinheiten gemessenen Signalen verwendet werden. Mehrere weitere Messeinheiten, an verschiedenen Stellen am Hals des Menschen angeordnet, können dafür genutzt eine räumliche Differenzierung der Oberflächennahen Karotiden im Hals zu erreichen. Die Gradienten der Bildgebungssequenz können auch zur Bildgebung mit der erfindungsgemäßen mindestens einen weiteren Messeinheit verwendet werden.

Die Wahl der Flipwinkel für die erfindungsgemäßen zusätzlichen **Anregungen 6** und **10** (zusätzlich zur Anregung 7 beim Stand der Technik) muss so erfolgen, dass der Kontrast zwischen der Signalamplitude im Gewebe und in der Arterie möglichst groß ist. Der Flipwinkel der letzten Anregung pro Schichtblock 10 muss so gewählt werden, dass die Gewebemagnetisierung, auf welche die Anregung 6 wirkt, zum Zeitpunkt der Messung der nächsten Schicht minimal ist.

### Bezugszeichenliste

- 1: Zu untersuchendes Lebewesen
- 2: Zu untersuchender Körperteil
- 3: Tomograph
- 4a: Erste Messeinheit (Gewebe)
- 4b: Weitere Messeinheit (Kontrastmittel/Blut)
- 5: Angeregte Schicht (für 4b)
- 6: Anregungspuls für die weitere Messeinheit 4b
- 7: Anregungspuls für die erste Messeinheit 4a
- 8: Bildgebungsblock
- 9: Auslese des Signals der weiteren Messeinheit
- 10: Zusätzlicher Anregungspuls
- A: Datenkanal erste Messeinheit
- B: Datenkanal weitere Messeinheit

### Literatur:

[1] L. ∅stergaard, R. Weisskoff, D. Chesler, C. Gyldensted, und B. Rosen: High resolution measurement of cerebral blood flow using intravascular tracer bolus passages. Part I: Mathematical approach and statistical analysis. Magn Reson Med, 36(5):715-25, 1996.
[2] L. Østergaard, A. Sørensen, K. Kwong, R. Weisskoff, C. Gyldensted, und B. Rosen: High resolution measurement of cerebral blood flow using intravascular tracer bolus passages. Part II: Experimental comparison and preliminary results. Magn Reson Med, 36(5):715-25, 1996.
[3] L. Østergaard: Patent DE000060024073T2: *System zu Bestimmung hämodynamischer Indizes mittels tomographischer Daten.*
[4] R. Newbould, S. Skare, T. Jochimsen, M. Alley, M. Moseley, G. Albers, R. Bammer: Perfusion mapping with multiecho multishot parallel imaging EPI. Magn Reson Med, 58(1):70-81, 2007
[5] F. Calamante, M. Morup, L. Hansen: Defining a local arterial input function for perfusion MRI using independent component analysis. Magn Reson Med, 52(4):789-797, 2004
[6] M. van Osch, E. Vonken, M. Viergever, J. van der Grond, and C. Bakker: Measuring the arterial input function with gradient echo sequences. Magn Reson Med., 49:1067-76, 2003.
[7] T. J. Carroll, H. A. Rowley, and V. M. Haughton: Automatic calculation of the arterial input function for cerebral perfusion imaging with mr imaging. Radiology, 227(2):593-600, May 2003.
[8] T. J. Carroll: US Patent 6546275: *Determination of the arterial input function in dynamic contrast-enhanced MRI*
[9] K. Mouridsen, S. Christensen, L. Gyldensted, and L. Ostergaard: Automatic selection of arterial input function using cluster analysis. Magn Reson Med, 55(3):524-531, Mar 2006.

## Patentansprüche

1. Tomographieeinrichtung (3) zur Erzeugung von Magnetresonanz-(MR-) Bildern eines in einem Messvolumen der Tomographieeinrichtung (3) angeordneten Körperteils (2) eines Lebewesens (1), mit einer ersten Messeinheit (4a) zur Aufnahme einer ortsaufgelösten zeitlichen Reihe von MR-Bildern des zu untersuchenden Körperteils (2), wobei die Zeitreihe von MR-Bildern den Durchgang eines in die Blutbahn des Lebewesens (1) injizierten Kontrastmittels durch ein im zu untersuchenden Körperteil (2) befindliches Organ darstellt,
**dadurch gekennzeichnet,**
**dass** mindestens eine weitere Messeinheit (4b) vorgesehen ist, die eine lokale Aufnahmespule umfasst, welche in der Nähe mindestens einer Arterie, die den in der Tomographieeinrichtung (3) angeordneten Körperteil (2) des Lebewesens (1) versorgt, die Konzentration des Kontrastmittels zeitaufgelöst und zeitgleich mit der Messung der durch die erste Messeinheit (4a) bestimmten zeitlichen Reihe von MR-Bildern misst.

2. Tomographieeinrichtung nach Anspruch 1, **dadurch gekennzeichnet, dass** die weitere Messeinheit (4b) als Oberflächenspule ausgebildet ist.

3. Tomographieeinrichtung nach einem der Ansprüche 1 oder 2, **dadurch gekennzeichnet, dass** die weitere Messeinheit (4b) an einem eigenen Datenaufnahmekanal (B) der Tomographieeinrichtung (3) angeschlossen ist.

4. Tomographieeinrichtung nach einem der vorhergehenden Ansprüche
**dadurch gekennzeichnet, dass** die weitere Messeinheit (4b) ein kleineres Messvolumen als die erste Messeinheit (4a) umschließt.

5. Tomographieeinrichtung nach einem der vorhergehenden Ansprüche,
**dadurch gekennzeichnet, dass** mindestens zwei weitere Messeinheiten (4b) vorgesehen sind.

6. Verfahren zum Betrieb einer Tomographieeinrichtung gemäß einem der Ansprüche 1 bis 5, **dadurch gekennzeichnet, dass** in einer Anregungsschicht (5) eine Anregung (6, 10) der Magnetisierung des innerhalb der mindestens einen Arterie geführten Blutes und/oder Kontrastmittels des zu untersuchenden Lebewesens (1) zeitlich vor und/oder nach einem Bildgebungsteil (7 und 8) der Messsequenz der ersten Messeinheit (4a) erfolgt.

7. Verfahren nach Anspruch 6, **dadurch gekennzeichnet, dass** ein Auslesevorgang (9) der weiteren Messeinheit (4b) zeitlich vor und/oder nach dem Bildgebungsteil (7 und 8) der Messsequenz der ersten Messeinheit (4a) erfolgt.

8. Verfahren nach Anspruch 7, **dadurch gekennzeichnet, dass** die Anregung (6, 10) der Magnetisierung des innerhalb der Arterie geführten Blutes und/oder Kontrastmittels des zu untersuchenden Lebewesens (1) vor und/oder nach dem Bildgebungsteil (7 und 8) der Messsequenz der ersten Messeinheit (4a) erfolgt, wobei der Auslesevorgang (9) der weiteren Messeinheit (4b) während und/oder nach dem Bildgebungsteil (7 und 8) der Messsequenz der ersten Messeinheit (4a) erfolgt.

9. Verfahren nach einem der Ansprüche 6 bis 8, **dadurch gekennzeichnet, dass** die Anregungsschicht (5) so dick gewählt ist, dass die durch den zeitlich veränderlichen Blutfluss in der mindestens einen Arterie verursachte Änderung des von weiteren Messeinheit (4b) aufgenommenen Signals vernachlässigbar klein ist.

10. Verfahren nach einem der Ansprüche 6 bis 9, **dadurch gekennzeichnet, dass** mindestens zwei Anregungsschichten (5) verwendet werden.

11. Verfahren nach einem der Ansprüche 6 bis 10, **dadurch gekennzeichnet, dass** der Kontrast zwischen der Arterie und dem die Arterie umgebenden Gewebe über die jeweiligen Flipwinkel der Anregungen (6, 10) der Magnetisierung eingestellt wird.

12. Verfahren nach einem der Ansprüche 7 bis 11, **dadurch gekennzeichnet, dass** nach der Anregung (6) und dem Auslesevorgang (9) vor dem Bildgebungsteil (7 und 8) der Messsequenz zusätzlich eine oder mehrere Anregungen mit Auslesevorgang nach dem Bildgebungsteil der Messsequenz mit variablen Anfangszeiten angeschlossen werden.

13. Verfahren nach einem der Ansprüche 6 bis 12, **dadurch gekennzeichnet, dass** die Bestimmung der Kontrastmittelkonzentration durch Isolation des durch das Kontrastmittel verursachten Spektrumanteils aus dem gemessenen MR-Signal der mindestens einen weiteren Messeinheit (4b) erfolgt.
